# EUROPEAN PATENT APPLICATION

(11) **EP 1 270 525 A1**
(43) Date of publication of application: **02.01.2003**
(21) Application number: 01610063.8
(22) Date of filing: 22.06.2001
(51) Int. Cl.: C03C 3/19, C03C 17/245, C23C 16/40

(54) **Devices for handling of liquids comprising biomolecules**

(71) Applicant: NKT Research A/S, 2605 Brondby (DK)
(72) Inventor: Winther-Jensen, Bjorn, 2100 Copenhagen (DK)
(74) Representative: Plougmann & Vingtoft A/S

(57) **Abstract**

The present invention relates to devices for handing of a liquid comprising biomolecules in which at least a part of the surface which comes in contact with the liquid consist of an amorphous material having a high content of phosphorous oxide (P₂O₅) and to a plasma polymerisation process for providing an amorphous material on a substrate.

## Description

### FIELD OF THE INVENTION

The present invention relates to devices for handing of a liquid comprising biomolecules in which at least a part of the surface which comes in contact with the liquid consist of an amorphous material having a high content of phosphorous oxide (P₂O₅).

### BACKGROUND OF THE INVENTION

Most biomolecules are known to adhere very strongly to surfaces - this is necessary a part of there nature! The high tendency to adhere to surfaces causes a lot of difficulties in laboratory work and in industrial processing and handling of biomolecules because samples or production batches will partially "disappear" in the process equipment or make it difficult to separate different biomolecules from each other. It is the aim of the present invention to overcome some of these problems.

Many efforts have been made to treat or coat surfaces to make a "non-stick" surface for biomolecules. Much work has focused on coatings with polyethylene-glycol (PEG) on different surfaces, because PEG is known to be a good "non-stick" agent. PEG is unfortunately water-soluble polymer which is not very strong, and PEG is not as such a "construction" material. PEG it however well suited for soft coatings. Bonding of PEG to surfaces has been due to many studies, and some systems are quite suitable for industrial use. Also plasma polymerisation of "PEG-like" coatings has been studied and shows good "non-stick" properties towards biomolecules (Yuliang J. Wu et al. University of Texas- Colloids and Surfaces B: Biointerfaces 18 (2000) 235-248).

Boron-phosphorous glass has been known for long time, especially since ICI made a lot development in the area in the 1970'ies. The aim for ICI was to make non-misting lenses (British Patent 1 404 914 (1973)), but it was later found that the boron-phosphorous glasses also could bee used as "non-fouling" windows for submarine use (U.K. patent application 48761/76). Later (slow) water-soluble boron-phosphorous glass was developed, also for sub-marine application (US 5614006 and US 4652097).

### BRIEF DESCRIPTION OF THE DRAWINGS

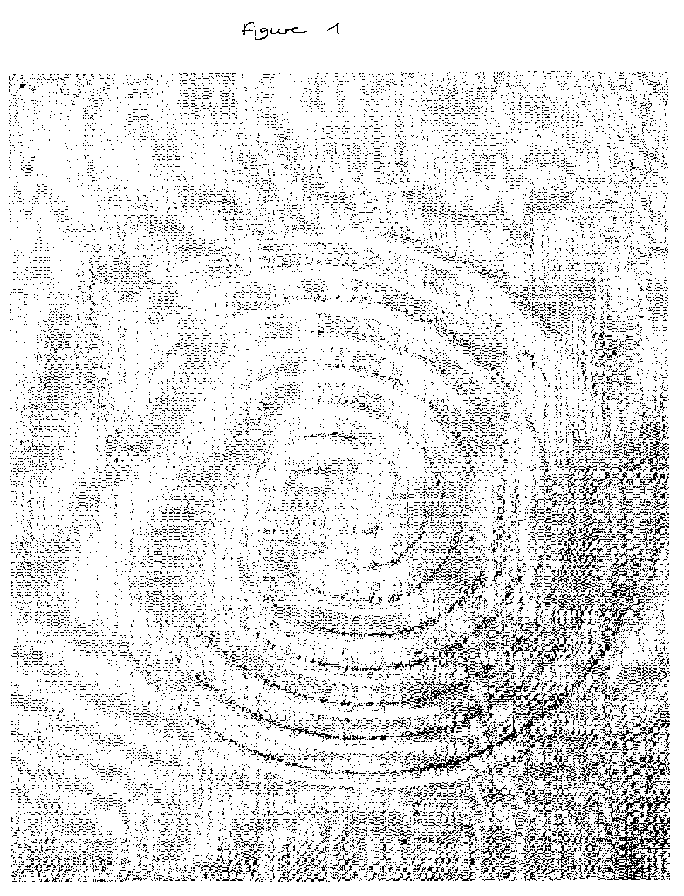

Figure 1 shows a phosphate glass slide according to example 1, were a spiral-shaped flow channel is milled. The dimension of the flow channel is 200x200 µm. The overall dimension of the spiral is 8 mm.

### DESCRIPTION OF THE INVENTION

The present invention provides devices for handling a liquid comprising biomolecules. It has been found that particular phosphate glass types have unique properties with respect to non-attachment of biomolecules, and that devices having surfaces consisting of such phosphate glasses are ideal for handling of a liquid comprising biomolecules in that biomolecules such as cells do not attach to device surfaces consisting of phosphate glass.

Without being limited to any particular theory, it is believed that the phosphate glass establishes a water film on the surface whereby the surface is recognised as water by the otherwise water-soluble biomolecules.

When used herein, the term "biomolecule" is intended to include molecules of biological origin, e.g. proteins, polypeptides, protein complexes, nucleic acid (such as RNA, DNA, etc), oligonucleotides, cells, micro organisms, etc. as well as derivatives thereof, and including analogues prepared by industrial or synthetic processes. Particularly relevant examples of biomolecules are cells, nucleic acids and proteins.

The devices of the present invention are adapted for handling a liquid comprising biomolecules, said device having a surface to become in contact with said biomolecules, at least a part of the surface consisting of an amorphous material comprising in the range of 50.0-70.0 mole% of P₂O₅, such as in the range of 55.0-67.0 mole%, e.g. in the range of 57.0-65.0 mole%.

In one embodiment, the phosphate glass also comprises boron. In such cases, the material of the device typically comprises in the range of 0.1-10 mole% of B₂O₃, such as in the range of 1.0-4.0 mole%, e.g. in the range of 2.0-3.0 mole%. Preferably, the combined content of P₂O₅ and B₂O₃ is in the range of 50-80 mole%, such as in the range of 50-75 mole%.

In one particular embodiment, the amorphous material comprises:
50.0-70.0 mole%, such as 55-65 mole%, of P₂O₅
1.0-6.0 mole%, such as 1.5-3.5 mole%, of B₂O₃
3.0-25.0 mole%, such as 10-20 mole%, of Na₂O
1.0-20.0 mole%, such as 3.0-15 mole%, of Li₂O
1.0-20.0 mole%, such as 5.0-15.0 mole%, of MgO and/or CaO.

In a more particular embodiment, the amorphous material consists of:
50.0-70.0 mole%, such as 55-65 mole%, of P₂O₅
1.0-6.0 mole%, such as 1.5-3.5 mole%, of B₂O₃
3.0-25.0 mole%, such as 10-20 mole%, of Na₂O
1.0-20.0 mole%, such as 3.0-15 mole%, of Li₂O
1.0-20.0 mole%, such as 5.0-15.0 mole%, of MgO and/or CaO
and 0-30 mole%, such as 0-10 mole% of other metal oxides, e.g. SiO₂, Al₂O₃, PbO, BaO, ZnO, SnO.

The present invention also provides a process for handling a liquid comprising biomolecules, said process comprising the step of bringing said liquid in contact with a device as defined herein. The device may in the form of a flow device, a housing,a compartment, a flask, a tube, a pipette, a vial, a cuvette, a sensor, a bulb, a particle in a larger compartment, etc.

### Preparation of amorphous material and devices

The phosphate glasses are traditionally prepared by mixing phosphorpentaoxide and boric acid with metal carbonates (e.g. Na, Li, Ca etc. carbonates). The mixture is then typically pre-melted at 350-400°C for 2 to 4 hours in order to eliminate crystal water and carbonates and afterwards heated to 650-800°C for 2-24 hours in order to achieve a sufficient sintering of the glass. At this temperature the material will be in the form of thick syrup. Such a general process, just as other processes known to the person skilled in the art, can be use in the preparation of the amorphous materials.

Carbon sources may also be included in the mixture, but carbon will normally escape in the form of CO₂ upon the heating at 650-800°C. If Al₂O₃ or Si₂O are added in amounts of more that a couple of percents, the amorphous material will normally become non-transparent. For some applications, this will be undesirable although the antifouling properties will remain substantially intact.

The amorphous material (phosphate glass) can be processed by known glass techniques as casting and blowing, but generally at a lower temperature than silica-glasses. This being said, containers, bottles and other laboratory equipments can easily be produced by normal techniques. The material can furthermore be embossed at around 300°C and milling, turning, drilling, grinding and polishing is possible even at room temperature. This means that the material is much more ductile (less brittle) than silica-glasses. This property makes prototyping easy in the material. Small structures (for flow canals, threads, etc.) can then bee obtained with hot embossing or by mechanical work up (see Example 1 and Figure 1).

The phosphate glass devices can be assembled by sintering pieces of glass (by 320-400°C), and it is envisaged that the glass can be welded with a UV- or IR light (laser).

Phosphorpentaoxide is very sensitive to moisture, expensive and demand special handling. By replacing the metal-carbonates of the mixture with metal-phosphates, the need for phosphorpentaoxide is lowered. The phosphorpentaoxide can be replaced and thereby completely eliminated by using methyl-phosphates, methyl-phosphites, phosphoric acid, phosphorus acid or a poly-phosphoric acid. Even if such other phosphorous compounds are used, a minor portion (e.g. less than 50 mole% of the phosphorous part) of phosphorpentaoxide may be used as a supplement.

When used herein, "device" is intended to mean an object of limited size such as at the most of size where the amorphous material of the device has a largest dimension of 15 cm such as 10 cm, e.g. 5 cm.

In one embodiment, the device is a flow canal consisting essentially of the amorphous material. The advantage of such a device is that attachment of biomolecules can be avoided and that clogging of the flow canal can be efficiently avoided.

Another embodiment relates to a particle comprising an amorphous material as defined herein. Such a particle may be used in chromatographic processes and has a particle of in the range of 50-5000 µm, such as 100-2000 µm.

The phosphate glass typically has a low degree of solubility, such as less than 2 nm per minute at 100°C, e.g. less than 1 nm per minute at 100°C, such as essentially insoluble at 100°C.

### Amorphous materials (phosphate glasses) on a substrate

In an alternative approach, the device may be prepared by plasma polymerisation of constituents so as to prepare an amorphous material (phosphate glasses) on a substrate.

In one embodiment, the plasma polymerisation process is used to prepare a device as defined above.

The present invention thus also provides a process for providing an amorphous material on a substrate, said process comprising the following steps of providing a substrate and plasma polymerising a mixture comprising an organophosphorous compound onto the substrate.

The organophosphorous compound may be selected from alkyl-phosphites and alkyl-phosphates, such as di-methyl-phosphite, tri-methyl-phosphite and tri-methyl-phosphate, e.g. those which as in the gaseous or liquid state at 25°C.

The mixture also comprises a boron compound, such as a boron compound selected from alkyl-borates and boroxines.

The mixture may further comprise a organosilicium compound, such as a organosilicium compound selected from silanes, siloxanes and silazanes. Even though silicon sources are somewhat undesirable for the phosphate glasses described above, plasma polymerisation makes it possible to prepare transparent amorphous materials in which silicon is included. It is believed that the plasma polymerisation process ensures that the SiO₂ and P₂O₅ becomes thoroughly mixed. Silicon may improved the mechanical properties and the solubility properties (less soluble). Furthermore, the yellowish tone which may occur in the amorphous materials prepared by melting can be reduced by inclusion of silicon.

In another - more general - embodiment, the process is used to prepare novel substrates having an amorphous material on the surface thereof. In this embodiment, the composition of the amorphous material is typically so that it comprises 15-75 mole%, such as 20-50 mole%, of P₂O₅
0-50 mole%, such as 2-30 mole%, of B₂O₃
0-85 mole%, such as 10-70 mole%, of SiO₂
0-80 mole%, such as 10-60 mole%, of CO₂
0-10 mole%, such as 1-5 mole%, of other constituents.

In a further embodiment, the amorphous material on the substrate consist of
15-75 mole%, such as 20-50 mole%, of P₂O₅
0-50 mole%, such as 2-30 mole%, of B₂O₃
0-85 mole%, such as 10-70 mole%, of SiO₂
0-80 mole%, such as 10-60 mole%, of CO₂
0-30 mole%, such as 1-10 mole%, of other metal oxides, e.g. Na₂O, Li₂O, Al₂O₃, PbO, BaO, ZnO, SnO, MgO, CaO.

The plasma polymerisation is accomplished by a multi-phase AC plasma. It has been found that this type of plasma has a level of intensity which allows a smooth deposition of the mixture onto the substrate. Examples of a multi-phase AC plasma are two or three phase AC plasma which offers the possibility of using a relatively low energy, e.g. energy levels of at the most 15 W/I such as at the most 10 W/I. Other types of generators of the plasma may also be applicable, e.g. RF and MF plasma and pulsed variants thereof.

The pressure in the plasma reaction chamber will normally be in the range of 10-1000 µbar, such as 25-500 µbar. The pressure in the reaction chamber is controlled by a vacuum pump, and a supply of an inert gas and the mixture (in gas form). The inert gas is suitably a noble gas such as helium, argon, neon, krypton or a mixture thereof. Hence, a plasma reaction chamber can be adapted in accordance with the instructions given herein with possible modification obvious for the person skilled in the art. The plasma polymerisation process is normally conducted for a period of 10-1000 sec, such as 20-500 sec.

The amorphous material can be provided on the substrate in a substantially uniform thickness if desired. It is believed that the layer thickness of the material generally is in the range of 5-5000 nm, such as in the range of 10-1000 nm, typically 10-200 nm.

The substrate may selected from a number of commercially available products of any chemical composition. Examples hereof are polymers, e.g. polyolefins such as polyethylene (PE) and polypropylene (PP), or other thermoplastics such as polytetrafluoroethylene (PTFE), tetra-fluoroethylene-hexafluoropropylen-copolymers (FEP), polyvinyl-difluoride (PVDF), polyamides (e.g. nylon-6.6 and nylon-11), and polyvinylchloride (PVC), rubbers e.g. silicon rubbers, glass, paper, carbon fibres, ceramics, metals, etc.

### Modification of the surface of the amorphous material

Modification of phosphate glass material by plasma polymerisation of, e.g., organic monomers is also possible. This gives the opportunity to introduce other surface functionalities (than non-stick) on the phosphate glass. For good bonding between glass and plasma coating a (plasma) reduction with H₂ of the glass surface is recommended just before the coating takes place.

As will be understood, hydrophobic, hydrophilic, cell-adhesive and other cell non-adhesive surface properties of predefined patches for the substrate may be provided by plasma polymerisation of a layer on top of the BF glass material through a mask being complementary to the desired patches. Thus, the surface properties can be provided components provided by a subsequent plasma polymerisation process.

In the process of preparing the cross-linked materials it is possible to add a monomer which provides hydrophilic properties either simultaneously with plasma polymerisation of substituted benzene or subsequent to plasma polymerisation of substituted benzene (see Example 2). Examples of monomers which can be combined with substituted benzenes or which can be polymerised in a subsequent step are acrylic acid, vinylacetate, ethanol, ethylenediamine, allylamine, vinylpyrolidone, vinylaniline, imidazoles such as vinylimidazole, or a mixture of acetylene and N₂O, etc.

When used herein, the term "cell-adhesive surface" is intended to refer to a surface with predominant adhesion to cells, i.e. a surface which promotes cell-attachment. Examples of monomers which provides a cell-adhesive surface area are acid and/or base groups, e.g. acrylic acid and allylamine, vinyldifluoride, and the like.

### Applications

It is believed that the present invention can provide devices for numerous purposes in which biomolecules are to be handled, e.g.:
- laboratory equipment such as containers for storage, culturing, etc. of cells, proteins and other biomolecules
- Flow systems including microflow systems, where uncontrolled attachment of biomolecules is undesired
- Filters including micro-filters and membranes where clogging of biomolecules normally occurs, e.g. for the food industry (cheese, milk, etc.), in breweries, in the pharmaceutical industry (purification and fermentation)
- Base material for beads for chromatographic processes.

It is also believed that the phosphate glass can be used for containers for crystal growth where attachment of crystals to the container is undesired.

### EXAMPLES

### Example 1 - A flow cell made in phosphate glass (boron-phosphor glass)

A boron-phosphor glass, with the composition (in mole %): 67.5% P₂O₅, 2.5% B₂O₃, 15% Na₂O, 5% Li₂O, 5% CaO and 5% MgO, was made by mixing trimethylphosphite, boric acid, sodium phosphate, lithium phosphate, calcium phosphate and magnesium phosphate in a crucible; heating to 450°C, keeping 450°C for 2 hours, further heating to 750°C and holding this temperature for 4 hours. The glass was cast in a hot (300°C) aluminium mould (30x60x5 mm).

After slow cooling to room temperature (over 12 hours), the glasses were grinded and polished. Flow structures, 200 µm and 400 µm wide was milled in half of the glasses using a programmable x-y milling machine. Connection to the flow structures was established by drilling 400 µm holes trough the glass.

The assembly of the flow cells was carried out by putting together a planar and a milled glass item followed by sintering at 340°C, equals approx. 40°C above the softening point of the glass.

After connecting the flow cell to an external pumping system, it was ready for use.
By testing with aqueous solutions of radioactive cells and proteins, it was seen that there was no adhesion of cells or proteins in the flow canals. This was the case both by continues pumping, with stationary liquid and by drying out the liquid in the canals. In all tests the flow canals was rinsed 3 times with clean water before the radioactivity was measured.

### Example 2 - Container for culturing or storage of cells and other bio-molecules

A boron-phosphor glass, with the composition (in mole %): 60.5% P₂O₅, 2.5% B₂O₃, 18% Na₂O, 9% Li₂O, 5% CaO, and 5% MgO was made by mixing trimethylphosphite, boric acid, sodium phosphate, lithium phosphate, calcium phosphate and magnesium phosphate in a crucible; heating to 350°C, keeping 350°C for 4 hours, further heating to 750°C and holding this temperature for 8 hours.

By cooling the glass to between 550°C and 620°C the glass reached a viscosity where blowing was possible and where known glass-forming techniques could be used. To tests were carried out:
1) A 250 ml container (jam glass) was blown in a wet wood mould.
2) A 200 ml container was made, by blowing the boron-phosphor glass *inside* a preheated (500°C) boron-silica glass (Pyrex) container. This gives a *coating* with boron-phosphor glass inside the Pyrex container.

In both cases the cooling to room temperature, was done over 24 hours.

The testing, of the containers was done by culturing human radioactive lever cells ("hot Hela") in the containers for one week. After rinsing the containers twice with clean water, no radioactivity could be measured.

### Example 3 - Cell-repelling phosphate glass (boron-phosphor glass) slide with cell-adhesive spots

A boron-phosphor glass of the same composition as in Example 1 was cast. After grinding and polishing planar glass slides on 30x60x3 mm was obtained.

A mask with 2x5 holes (2 mm in diameter) was prepared in a PE film and mounted with an adhesive on the glass slides. (Without adhesive in the "holes")

The glass slides was placed in a 12 liter MPAC (multi-phase AC) plasma polymerizing chamber. The chamber was evacuated and the pressure was levered to 0.01 mbar, H₂ with a flow of 10 sccm was started, the pressure was raised to 0.05 mbar and a plasma was turned on with a effect of 5 W/liter. Hereby the glass surface was cleaned and reduced where the holes in the mask allows it. After 180 seconds the first monomer gas (xylene) was flowed to the chamber with a flow rate of 15 sccm and the H₂ flow was changed to an argon flow of 10 sccm. After another 30 seconds the second monomer gas (vinyl-pyridine) was flowed to the chamber with a flow rate of 10 sccm, the xylene flow was turned off, the pressure was raised to 1.5 mbar and the effect was lowered to 0.3 W/liter. After 60 seconds with polymerizing vinyl-pyridine the plasma was turned off, all flows were stopped and the pressure was raised to atmospheric pressure. The mask was taken off and the slide is ready fore use.

The slide was placed in a solution of the biomolecules (cells), which were to be investigated. After 60 minutes the slide was removed from the solution and rinsed twice in clean water. Hereafter the cells only remained on the plasma polymerized spots.

### Example 4 - Plasma-polymerizing phosphoroxide for the preparation of coatings with non-fouling properties

Polystyrene slides (25x70x1.5 mm) were placed in a 12 liters MPAC (multi-phase AC) plasma polymerisations camber. The pressure was lowered to 0.01mbar. A flow of laughing gas (N₂O) of 30 sccm is started and the pressure was raised to 0.1 mbar. A plasma with an effect of 8 W/liter was turned on. After 20 seconds, a flow of trimethylphosphite (TMP) (10 sccm) and hexamethyldisiloxane (HMDSO) (5 sccm) was started. After another 60 seconds of polymerisation, the plasma was turned off, all flows were stopped and the pressure was raised to atmospheric pressure.

The contact angel of water on the coated polystyrene slides is 0° and the slides showed non-fouling properties in tests with proteins and cells.

By XPS (ESCA) analyses it was found that the composition of the coating was (by mole%) 15% phosphor, 12% silicium, 10% carbon, 1% nitrogen and 62 % oxygen, corresponding to about 24% P₂O₅, 39% SiO₂ and 32% carbon.

## Claims

1. A device for handling a liquid comprising biomolecules, said device having a surface to become in contact with said biomolecules, at least a part of the surface consisting of an amorphous material comprising in the range of 50.0-70.0 mole% of P₂O₅, such as in the range of 55.0-67.0 mole%, e.g. in the range of 57.0-65.0 mole%.

2. A device according to claim 1 comprising in the range of 0.1-10 mole% of B₂O₃, such as in the range of 1.0-4.0 mole%, e.g. in the range of 2.0-3.0 mole%.

3. A device according to any of the preceding claims, wherein the combined content of P₂O₅ and B₂O₃ is in the range of 50-80 mole%, such as in the range of 50-75 mole%.

4. A device according to any of the preceding claims, wherein the amorphous material comprises:
50.0-70.0 mole%, such as 55-65 mole%, of P₂O₅
1.0-6.0 mole%, such as 1.5-3.5 mole%, of B₂O₃
3.0-25.0 mole%, such as 10-20 mole%, of Na₂O
1.0-20.0 mole%, such as 3.0-15 mole%, of Li₂O
1.0-20.0 mole%, such as 5.0-15.0 mole%, of MgO and/or CaO

5. A device according to any of the preceding claims which is a flow canal consisting essentially of the amorphous material.

6. A particle comprising an amorphous material as defined in any of the claims 1-4.

7. A process for handling a liquid comprising biomolecules, comprising the step of bringing said liquid in contact with a device as defined in any of the claims 1-6.

8. A process for providing an amorphous material on a substrate, said process comprising the following steps of providing a substrate and plasma polymerising a mixture comprising an organophosphorous compound onto the substrate.

9. A process according to claim 8, wherein the organophosphorous compound is selected from alkyl-phosphites and alkyl-phosphates, such as di-methyl-phosphite, tri-methyl-phosphite and tri-methyl-phosphate, such as those which as in the gaseous or liquid state at 25°C.

10. A process according to any of the claims 8-9, wherein the mixture also comprises a boron compound, such as a boron compound selected from alkyl-borates and boroxines.

11. A process according to any of the claims 8-10, wherein the mixture also comprises a organosilicium compound, such as a organosilicium compound selected from silanes, siloxanes and silazanes.

12. A process according to any of the claims 8-11, wherein the amorphous material has the following composition:
15-75 mole%, such as 20-50 mole%, of P₂O₅
0-50 mole%, such as 2-30 mole%, of B₂O₃
0-85 mole%, such as 10-70 mole%, of SiO₂
0-80 mole%, such as 10-60 mole%, of CO₂
0-10 mole%, such as 1-5 mole%, of other constituents.
